# EUROPÄISCHE PATENTANMELDUNG

(11) **EP 4 425 124 A1**
(43) Veröffentlichungstag der Anmeldung: **04.09.2024**
(21) Anmeldenummer: 23159099.3
(22) Anmeldetag: 28.02.2023
(51) Int. Cl.: G01H 11/08, G01H 11/04, G01R 19/00

(54) **VERFAHREN ZUR BESTIMMUNG EINES ALTERUNGSZUSTANDES EINER KONTAKTIERUNGSSCHICHT EINES HALBLEITERBAUELEMENTES SOWIE HALBLEITERBAUGRUPPE**

(71) Anmelder: Siemens Aktiengesellschaft, 80333 München (DE)
(72) Erfinder: Bickel, Heinz Dietrich Philipp, 81677 München (DE); Kriegel, Kai, 81739 München (DE); Mitic, Gerhard, 81827 München (DE); Stegmeier, Stefan, 81825 München (DE)
(74) Vertreter: Siemens Patent Attorneys

(57) **Zusammenfassung**

Die Erfindung betrifft ein Verfahren zur Bestimmung eines Alterungszustandes einer Kontaktierungsschicht zur Befestigung eines Halbleiterbauelements (2) in einer Halbleiterbaugruppe (4) umfassend folgende Schritte:
- Aufbringen einer ersten Kontaktierungsschicht (6) auf eine Trägerschicht (8), zur Befestigung des Halbleiterbauelement (2) auf dieser Trägerschicht (8),
- wobei auf dem Halbleiterbauelement (2) auf der der ersten Kontaktierungsschicht (6) abgewandten Seite (10) eine zweite Kontaktierungsschicht (12) aufgebracht ist,
- Anbringen eines Emitters (14) und eines Sensors (16) an der Halbleiterbaugruppe (4) die zur Bestimmung einer Oberflächenbeschaffenheit einer Oberfläche (13) der zweiten Kontaktierungsschicht (12) dienen,
- Verbinden des Sensors (16) mit einer Auswerteelektronik (18) für aufgenommene Sensordaten,
- Versetzen der Halbleiterbaugruppe (4) in einen betriebsbereiten Zustand und Betrieb der Halbleiterbaugruppe (4) und
- Auswerten der Sensordaten mittels der Auswerteelektronik (18) im betriebsbereiten Zustand der Halbleiterbaugruppe (4) zur Ermittlung eines Oberflächenbeschaffenheits-Kennwertes der zweiten Kontaktierungsschicht (12).

## Beschreibung

Die Erfindung betrifft ein Verfahren zur Bestimmung eines Alterungszustandes einer Kontaktierungsschicht zur Befestigung eines Halbleiterbauelementes in einer Halbleiterbaugruppe nach Patentanspruch 1, sowie des Alterungszustandes einer Bonddrahtverbindung in einer Halbleiterbaugruppe, sowie eine Halbleiterbaugruppe nach Patentanspruch 12.

In Halbleiterbaugruppen, insbesondere für Leistungselektronik sind verschiedene Halbleiterbauelemente, wie beispielsweise IGBTs, MOSFETS oder Dioden auf Substraten bzw. Leiterplatten verbaut. Dabei ist zur Kontaktierung der Halbleiterbauelemente in der Regel eine Kontaktierungsschicht vorgesehen, unter die beispielsweise auch ein Lotschicht fällt. Insbesondere Leistungselektronikbauelemente sind jedoch einer sehr hohen thermomechanischen Belastung im Betrieb ausgesetzt. Deshalb besteht bei Leistungselektronikbauelementen eine höhere Gefahr des zufälligen Ausfalls aufgrund von Alterungsbedingungen, weshalb ein stetiger Bedarf zur Einschätzung über den Alterungszustand einer jeweiligen Baugruppe besteht. Hierzu werden beispielsweise nach dem Stand der Technik elektrische Messgrößen wie z. B. die Gate-Emitter-Spannung oder auch der Einschaltstrom vermessen. Durch die Änderung des thermischen Widerstands durch mögliche Delaminationen oder Risse in einer Kontaktierungsschicht kann dabei auf ein bestimmtes Alterungsverhalten geschlossen werden. Diese Messungen sind im Allgemeinen jedoch sehr aufwändig, da sie hohe Messgenauigkeit und eine hohe zeitliche Auflösung benötigen. Diese sind in der Regel nicht im Betrieb des Halbleiterbauelementes durchführbar, sondern es bedarf hierzu Laborbedingungen, um die genannten aufwändigen und genauen Messungen zu realisieren. Ferner ist es auch während des Betriebes eines Leistungselektronikbauteiles, beispielsweise im Betrieb eines Elektrofahrzeuges, unter realen Bedingungen nicht möglich, das Bauelement bzw. die Baugruppe auszubauen und entsprechende Lötstellen oder Kontaktierungsschichten mikroskopisch zu begutachten. Des Weiteren kann über die Auswertung temperatursensitiver Parameter und in Lebensdauertests ermittelter Temperaturzyklen der Alterungszustand geschätzt werden. Die Messung dieser temperatursensitiven Parameter ist jedoch ebenfalls sehr aufwändig.

Die Aufgabe der Erfindung besteht darin, ein Verfahren zur Bestimmung eines Alterungszustandes einer Kontaktierungsschicht eines Halbleiterbauelementes in einer Halbleiterbaugruppe sowie eine Halbleiterbaugruppe an sich bereitzustellen, wobei die Bestimmung des Alterungszustandes während des Betriebs oder zumindest im betriebsbereiten Zustand des Bauelementes bzw. der Halbleiterbaugruppe erfolgt.

Die Lösung der Aufgabe besteht in einem Verfahren nach dem Patentanspruch 1 sowie in einer Halbleiterbaugruppe mit den Merkmalen des Patentanspruchs 12.

Das Verfahren nach Patentanspruch 1 zur Bestimmung eines Alterszustandes einer Kontaktierungsschicht zur Befestigung eines Halbleiterbauelementes in einer Halbleiterbaugruppe umfasst dabei folgende Schritte:
- Aufbringen einer ersten Kontaktierungsschicht auf eine Trägerschicht zur Befestigung des Halbleiterbauelementes auf dieser Trägerschicht,
- wobei auf dem Halbleiterbauelement auf der der ersten Kontaktierungsschicht abgewandten Seite eine zweite Kontaktierungsschicht aufgebracht ist,
- Anbringen eines Emitters und eines Sensors an der Halbleiterbaugruppe, die zur Bestimmung einer Oberflächenbeschaffenheit einer Oberfläche der zweiten Kontaktierungsschicht dienen,
- Verbinden des Sensors mit einer Auswerteelektronik für aufgenommene Sensordaten,
- Versetzen der Halbleiterbaugruppe in einen betriebsbereiten Zustand und Betrieb der Halbleiterbaugruppe und
- Auswerten der Sensordaten mittels der Auswerteelektronik im betriebsbereiten Zustand der Halbleiterbaugruppe zur Ermittlung eines Oberflächenbeschaffenheits-Kennwertes der zweiten Kontaktierungsschicht.

Die in diesem Zusammenhang verwendeten Begriffe seien dabei wie folgt definiert:
Eine Kontaktierungsschicht ist eine Schicht, die dazu dient, eine elektrische Kontaktierung herzustellen. Dabei handelt es sich in der Regel um eine metallische Schicht, die eine entsprechende elektrische Leitfähigkeit aufweist. Grundsätzlich wird hierunter auch eine Lotschicht verstanden, es kann allerdings auch in diese Lotschicht oder separat hierzu sich um eine metallische Folie handeln. Auch ein Lottropfen, der zur Befestigung eines Bonddrahtes dient, kann als Kontaktierungsschicht bezeichnet werden.

Ein Halbleiterbauelement ist, wie bereits einleitend erwähnt, beispielsweise ein IGBT, ein Transistor oder eine Diode. In dem Zusammenhang wird insbesondere von Leistungselektronikbauelementen gesprochen. Das beschriebene Verfahren ist jedoch auch ohne Weiteres auf sonstige Halbleiterbauelemente anwendbar. Eine Halbleiterbaugruppe ist eine Baugruppe, bei der mindestens ein Halbleiterbauelement auf ein Substrat montiert ist und entsprechende Kontaktierungen vorliegen.

Bei der ersten Kontaktierungsschicht handelt es sich dabei um eine Kontaktierung zwischen dem Halbleiterbauelement und einer Trägerschicht. Dabei ist die Trägerschicht in der Regel auch wieder eine elektrisch leitende Schicht wie beispielsweise eine Kupferschicht oder eine Kupferplatte. Die Trägerschicht kann allerdings je nach Zusammensetzung der Halbleiterbaugruppe auch eine nicht leitende Schicht oder Platte wie beispielsweise ein keramisches Substrat sein. Das Halbleiterbauelement ist dabei mit dieser Trägerschicht über die erste Kontaktierungsschicht kontaktiert, sodass das Halbleiterbauelement die erste Kontaktierungsschicht im Wesentlichen verdeckt, sodass eine direkte Alterungsbestimmung auch dieser Kontaktierungsschicht zumindest direkt kaum möglich ist. Eine zweite Kontaktierungsschicht des Halbleiterbauelementes ist auf einer der ersten Kontaktierungsschicht und der Trägerschicht abgewandten Seite, also auf der gegenüberliegenden Seite auf dem Halbleiterbauelement angebracht. Diese zweite Kontaktierungsschicht ist in der Regel mit einem Kontaktierungsdraht zur Kontaktierung verbunden.

Ferner sind verfahrensgemäß ein Emitter und ein Sensor an der Halbleiterbaugruppe angebracht, die zur Bestimmung einer Oberflächenbeschaffenheit einer Oberfläche der zweiten Kontaktierungsschicht dienen. Emitter und Sensor können dabei bevorzugt in einem integrierten Bauteil untergebracht sein. Für den Fall zur Messung von Wellen wie elektromagnetischen Wellen ist der Emitter beispielsweise eine Diode, ein Laser oder ein anderes elektromagnetische Wellen ausstrahlendes Element. Der Sensor wiederum ist dazu geeignet, insbesondere von der Oberfläche reflektierte Wellen wie beispielsweise elektromagnetische Wellen, aber auch mechanische Wellen, wie Schallwellen zu detektieren. Durch das Ausstrahlen und Reflektieren von Wellen können Änderungen von Oberflächenbeschaffenheiten der Oberfläche der zweiten Kontaktierungsschicht ermittelt werden. Hierzu ist eine Auswerteelektronik erforderlich, die in Verbindung mit dem Sensor steht und an die Sensordaten, also Informationen über die reflektierten Wellen auszuwerten. Bei Emittern als Emitter für Wellen handelt es sich dabei lediglich um ein Beispiel, als Emitter kann auch im weiteren Sinne das Aufbringen eines elektrischen Stroms oder eines elektrischen Potenzials an der Oberfläche mittels einer Elektrode verstanden werden, wobei der Sensor wiederum eine Messeinheit ist, die hierbei einen elektrischen Widerstand und eine Kapazität misst. Die Oberfläche der zweiten Kontaktierungsschicht kann auch ein Bonddraht sein, der auf der zweiten Kontaktierungsschicht angebracht ist. Auch dessen Oberfläche lässt sich in vorteilhafter Weise in Hinblick auf eine Alterung beobachten.

Unter dem Begriff betriebsbereiter Zustand oder Betrieb der Halbleiterbaugruppe wird dabei verstanden, dass sowohl Emitter als auch Sensor so in die Halbleiterbaugruppe eingebaut sind, dass eine Messung und Auswertung der Oberflächenbeschaffenheit während des Betriebes der Halbleiterbaugruppe bzw. zumindest in einem Einbauzustand in einem betriebsbereiten Zustand, also in situ erfolgt.

Der Begriff Oberflächenbeschaffenheit bedeutet dabei, dass die Oberfläche der zweiten Kontaktierungsschicht sich durch insbesondere thermomechanische Spannungen im Laufe des Betriebes verändert. Beispielsweise wachsen hierbei sogenannte Hillocks, also nadelförmige Spitzen aus. Diese Auswucherungen in Form von Hillocks auf der Oberfläche bedeuten jedoch auch eine Verarmung von Material an anderen Stellen in der zweiten Kontaktierungsschicht. Derartige Hillocks oder allgemein Oberflächenveränderungen sind im Betrieb von Kontaktierungsschichten durchaus üblich und bis zu einem gewissen Grad vertretbar. Jedoch weist die Anzahl derartiger Oberflächenveränderungen auf einen Alterungszustand der Kontaktierungsschicht hin und es kann empirisch ermittelt werden, welcher gerade noch akzeptabler Alterungszustand der Halbleiterbaugruppe mit welcher Oberflächenbeschaffenheit korreliert. Auf diese Weise kann mittels der aufgenommenen Sensordaten durch die Auswerteelektronik im betriebsbereiten Zustand der Halbleiterbaugruppe ein Oberflächenbeschaffenheits-Kennwert ermittelt werden.

Im Gegensatz zum Stand der Technik ist das beschriebene Verfahren dazu geeignet, eine verwertbare Information über den Alterungszustand einer Halbleiterbaugruppe während des Betriebes dieser Baugruppe zu bestimmen, was es ermöglicht, diese Baugruppe gegebenenfalls rechtzeitig auszutauschen, bevor es zu einem Versagen kommt.

Für die Ermittlung dieses Alterungszustandes ist in einer Datenbank bevorzugt ein Toleranzbereich für den Oberflächenbeschaffenheits-Kennwert hinterlegt und durch die Auswerteelektronik wird eine Information ausgeschickt, wenn ein ermittelter Oberflächenbeschaffenheits-Kennwert außerhalb dieses Toleranzbereiches liegt. Diese Information kann beispielsweise an eine Steuerelektronik geschickt werden, die wiederum eine Information auf einem Display anzeigt, dass ein Austausch der Baugruppe nötig ist.

Im Weiteren hat es sich herausgestellt, dass eine Korrelation zwischen dem Alterungszustand der ersten Kontaktierungsschichten, also der Kontaktierungsschicht, die durch den Sensor nicht beobachtet werden kann, da sie durch das Halbleiterbauelement verdeckt ist, und der zweiten Kontaktierungsschicht bzw. der Oberflächenbeschaffenheit besteht. Das heißt, dass in der Praxis eine Korrelation zwischen beispielsweise einer Anzahl von Hillocks pro Flächeneinheit und einer Anzahl von Mikrorissen in der ersten Kontaktierungsschicht besteht. Diese Korrelation wird wiederum empirisch bestimmt, woraus eine Korrelationsfunktion abgeleitet werden kann. Somit kann ein Alterungskennwert der ersten Kontaktierungsschicht aus dem Oberflächenbeschaffenheits-Kennwert der zweiten Kontaktierungsschicht ermittelt werden, wobei die entsprechende Korrelationsfunktion ebenfalls in der Datenbank hinterlegt ist. Es ist dabei anzumerken, dass sowohl die Auswertelektronik als auch die Datenbank auf einem integrierten Schaltkreis zusammengefasst sein können, der wiederum ein integraler Bestandteil der Halbleiterbaugruppe sein kann. Auf diese Weise kann durch das beschriebene Verfahren nicht nur auf die Alterung der zweiten Kontaktierungsschicht, sondern auch auf die Alterung der ersten, an sich verdeckten, Kontaktierungsschicht geschlossen werden.

In einer weiteren Ausgestaltungsform der Erfindung wird die Information durch die Auswerteelektronik dann ausgeschickt, wenn der durch die Korrelationsfunktion ermittelte Alterungskennwert außerhalb des Toleranzbereichs liegt.

In einer weiteren bevorzugten Ausgestaltungsform der Erfindung ist der Sensor auf oder an der Oberfläche der zweiten Kontaktierungsschicht angebracht. Der Sensor ist ferner bevorzugt in einem integralen Bauteil mit dem Emitter ausgestaltet. Dieses Bauteil kann auf der Oberfläche der zweiten Kontaktierungsschicht gut aufgebracht werden, sodass dieser fest an der Oberfläche angebracht ist und stets verlässliche Messdaten liefert. Bei den Emittern kann es sich dabei entweder, wie bereits erwähnt, um Emitter von elektromagnetischen Wellen, jedoch auch von Schallwellen handeln. Für die Aussendung von Schallwellen sind insbesondere Piezoaktoren oder MEMS-Aktoren geeignet. Entsprechende damit zusammenwirkende Sensoren sind dazu geeignet, diese Schallwellen bzw. mechanische Wellen zu detektieren.

Ein weiterer Bestandteil der Erfindung ist eine Halbleiterbaugruppe mit den Merkmalen des Patentanspruchs 12. Diese Halbleiterbaugruppe umfasst mindestens ein Halbleiterbauelement, wobei das Halbleiterbauelement mittels einer ersten Kontaktierungsschicht mit einer Trägerschicht verbunden ist und das Halbleiterbauelement auf einer der ersten Kontaktierungsschicht abgewandten Seite eine zweite Kontaktierungsschicht aufweist. Die Erfindung zeichnet sich dabei dadurch aus, dass ein Emitter und ein Sensor an der Halbleiterbaugruppe angebracht sind, sodass in einem betriebsbereiten Zustand der Halbleiterbaugruppe mittels des Emitters eine Beeinflussung einer Oberfläche der zweiten Kontaktierungsschicht erfolgt, die von dem Sensor detektierbar ist. Dabei steht der Sensor mit einer Auswerteelektronik zur Auswertung der Sensordaten und zur Ermittlung eines Oberflächenbeschaffenheits-Kennwertes der Oberfläche in Verbindung.

Die beschriebene Halbleiterbaugruppe weist die analogen Merkmale wie das Verfahren als Vorrichtungsmerkmale auf, wobei die verwendeten Begriffe identisch definiert sind. Dabei weist die Halbleiterbaugruppe auch die gleichen Vorteile auf, die bereits bezüglich des Verfahrens erläutert sind. Diese sind insbesondere die Möglichkeit, die Halbleiterbaugruppe während des Betriebes auf Alterungserscheinungen von Kontaktierungsschichten zu überprüfen und einen frühzeitigen Ausbau der Halbleiterbaugruppe anzuzeigen. Auch bei dieser Halbleiterbaugruppe ist es zweckmäßig, dass mittels des Emitters elektromagnetische oder mechanische Wellen ausgesandt werden, die mittels des Sensors detektiert werden. Alternativ zu der Wellenemission ist es auch zweckmäßig, einen Emitter so auszugestalten, dass ein resistives oder kapazitives Signal durch den Sensor detektiert wird.

Das direkte oder zumindest mit einer geringen Beabstandung Anbringen des Emitters und/oder des Sensors bzw. eines integrierten Bauteils, das Emitter und Sensor enthält, an der zweiten Kontaktierungsschicht ist für eine störungsfreie Messung während des Betriebes oder im Betriebszustand der Halbleiterbaugruppe zweckmäßig.

Vorteilhafte Ausgestaltungsformen und weitere Merkmale der Erfindung werden anhand der folgenden Figuren näher erläutert. Merkmale mit derselben Bezeichnung aber in unterschiedlicher Ausgestaltung, werden dabei jeweils mit demselben Bezugszeichen versehen.

Dabei zeigen:
- Figur 1: einen schematischen Querschnitt durch eine Halbleiterbaugruppe mit Halbleiterbauelement und Sensor zur Bestimmung eines Alterungszustandes,
- Figur 2: eine vergrößerte Darstellung einer Kontaktierungsschicht mit herauswachsenden Hillocks,
- Figur 3: eine schematische Darstellung der Übermittlung von Sensordaten an eine Auswerteelektronik,
- Figur 4: eine schematische Darstellung eines Halbleiterbauelementes mit einer Kontaktierungsschicht und deren Oberfläche mit darauf angeordneten Kombinationen von Sensor und Emitter, und
- Figur 5: eine vergleichbare Darstellung wie in Figur 4 in alternativer Ausgestaltungsform.

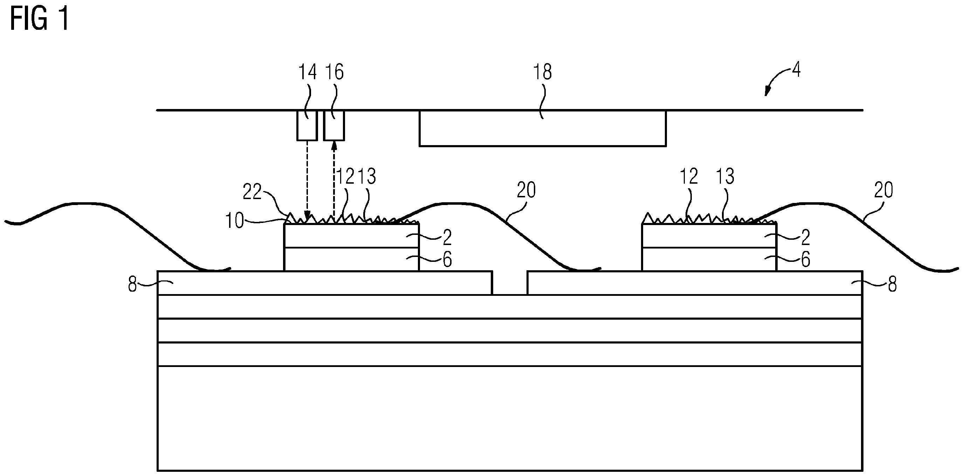

In Figur 1 ist ein Ausschnitt aus einer Halbleiterbaugruppe 4 dargestellt, die eine Mehrzahl von hier nicht näher benannten Schichten, Substraten und Bodenplatten aufweisen kann, wobei auch übereinander gebaut mehrere derartige Ausschnitte die gesamte Halbleiterbaugruppe 4 bilden können. Die Beschreibung hierbei soll zunächst auf eine Trägerschicht 8 gerichtet sein, die in der Regel eine elektrisch leitende Schicht, wie beispielsweise eine Kupferplatte, ist. Auf diese ist eine erste Kontaktierungsschicht 6, beispielsweise in Form einer Lotschicht, aufgebracht, auf der ein Halbleiterbauelement, beispielsweise ein IGBT, aufgelötet ist. Dieses Halbleiterbauelement 2 weist dabei wiederum auf einer der ersten Kontaktierungsschicht 6 abgewandten Seite 10 eine zweite Kontaktierungsschicht 12 auf, deren Oberfläche 13 mittels eines Emitters 14 und eines Sensors 16 beobachtet wird.

Auf dieser zweiten Kontaktierungsschicht 12 ist wiederum ein Kontaktierungsdraht 20 elektrisch leitend kontaktiert. Die Oberfläche 13 der zweiten Kontaktierungsschicht 12 ist in Figur 1 stark übertrieben dargestellt, wobei hier Spitzen dargestellt sind, die in der Fachsprache Hillocks genannt werden. Diese Hillocks entstehen aufgrund von thermomechanischen Belastungen im Betrieb der Halbleiterbaugruppe 4.

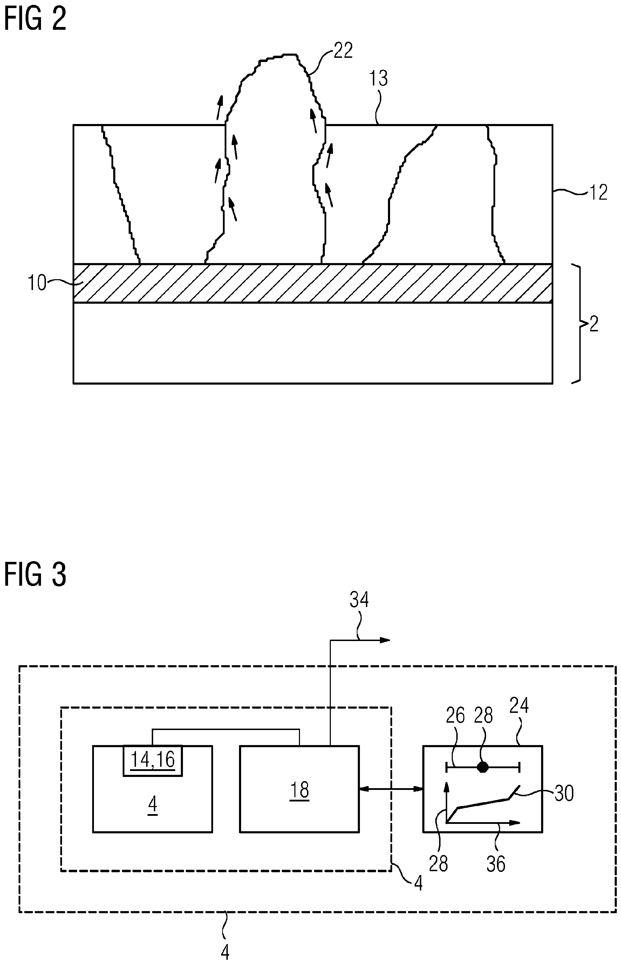

In dem Beispiel gemäß Figur 1 ist der Emitter 14 in Form einer Diode zur Aussendung von elektromagnetischen Wellen mit einer bestimmten Wellenlänge ausgestaltet. Der Sensor 16 ist hierbei ein Sensor zur Detektierung von elektromagnetischen Wellen in der ausgesandten Wellenlänge bzw. in deren Größenordnung. Die Kombination aus Emitter 14 und Sensor 16 ist hierbei knapp oberhalb der zweiten Kontaktierungsschicht 12 in direkter Betrachtungslinie zu dieser angeordnet. Der Abstand zwischen Emitter 14, Sensor 16 und der Oberfläche 13 ist in Figur 1 stark übertrieben dargestellt. Dabei sind diese beiden Bauteile möglichst nah an der Oberfläche 13, bevorzugt, wie dies auch in den weiteren Figuren noch beschrieben werden wird, direkt auf der Oberfläche 13 angeordnet. In dem hier dargestellten Beispiel herrscht jedoch ein Abstand von ca. 2 mm, bevorzugt weniger als 5 mm, wobei Emitter 14 und Sensor 16 an einer weiteren, hier nicht näher spezifizierten Platte oberhalb des Halbleiterbauelementes 2 angeordnet sind. Ferner ist an dieser ebenfalls nicht benannten Platte eine Auswerteelektronik 18 in Form eines integrierten Schaltkreises mit einer darin ebenfalls integrierten Datenbank angeordnet. Der Sensor 16 steht in direktem Kontakt mit dieser Auswertelektronik 18 und übermittelt an diese die gemessenen Sensordaten. Die Auswerteelektronik 18 wiederum berechnet, wie in Figur 3 schematisch dargestellt ist, in Wechselwirkung mit der Datenbank 24 einen Oberflächenbeschaffenheits-Kennwert 28. Für diesen Kennwert 28 ist ein Toleranzband bzw. Toleranzbereich 26 (vgl. Figur 3) vorgesehen.

Der Oberflächenbeschaffenheits-Kennwert 28 wird anhand von einer Anzahl pro Flächeneinheit bzw. einer durchschnittlichen Höhe von Hillocks 22 bestimmt. Hierzu liegen empirische Daten vor, die beispielsweise mikroskopisch im Labor aufgenommen werden. Hierbei wird ermittelt, welche Anzahl bzw. welche Höhe pro Flächeneinheit an Hillocks 22 für eine sichere Kontaktierung und für eine sichere Wirkungsweise der zweiten Kontaktierungsschicht 12 noch vertretbar sind. Ein Beispiel für ein Hillock ist in Figur 2 in einer stark vergrößerten und stark schematisierten Form abgebildet. Aus diesen empirischen Werten wird neben dem ermittelten Oberflächenbeschaffenheits-Kennwert 28 eben auch dieser Toleranzbereich 26 festgelegt. Diese Werte 26 und 28 sind in der Datenbank 24 gespeichert. Wird mittels der Auswerteelektronik 18 anhand der übermittelten Sensordaten ein Oberflächenbeschaffenheits-Kennwert 28 ermittelt, der außerhalb des Toleranzbereiches 26 liegt, so wird mittels der Auswerteelektronik 18 ein Signal 34 ausgesandt, das beispielsweise an eine weitere, hier nicht dargestellte Elektronik zur weiteren Verarbeitung übermittelt wird. Diese weitere Elektronik kann dann wiederum auf einem hier ebenfalls nicht dargestellten Display anzeigen, dass die Halbleiterbaugruppe 4 in einem bestimmten Zeitraum ausgetauscht werden muss. So kann beispielsweise bei einem Elektrofahrzeug Informationen über den Alterungszustand der Kontaktierung in der Halbleiterbaugruppe, insbesondere einer Leistungshalbleiterbaugruppe in der Bordelektronik hinterlegt werden und bei einem Wartungsintervall ausgelesen werden.

Die jeweils gestrichelten Kästen um die einzelnen Baugruppen 4, 18 und 24 also der Halbleiterbaugruppe 4, der Auswertelektronik 18 und der Datenbank 24 sollen veranschaulichen, dass diese jeweiligen Baugruppen hochintegriert oder vollständig getrennt ausgestaltet werden können. Bevorzugt ist die Auswerteelektronik 18 innerhalb der Halbleiterbaugruppe integriert, die Halbleiterbaugruppe kann jedoch auch zur Auswertung der Sensordaten auf eine hiervon räumlich weit getrennte Auswerteelektronik 18 zurückgreifen. Auch die Datenbank 24 kann direkt in der Halbleiterbaugruppe 4 integriert sein, sie kann aber auch auf einem getrennten Bauelement gegebenenfalls sogar in einer Cloud vorliegen.

In einer weiteren Ausgestaltung der Erfindung kann auch noch ein empirischer Zusammenhang zwischen der ersten Kontaktierungsschicht 6 und der zweiten Kontaktierungsschicht 12 in der Datenbank 24 hinterlegt sein. Diese sind insofern besonders vorteilhaft, da durch das Halbleiterbauelement 2 ein direkter Blick des Sensors 16 auf die erste Kontaktierungsschicht 6 verdeckt ist. Auch hier kann empirisch unter Laborbedingungen gemessen werden, welche Oberflächenbeschaffenheit der zweiten Kontaktierungsschicht 12 mit welchem Alterungszustand der ersten Kontaktierungsschicht 6 in der Praxis korreliert. Hieraus kann eine Korrelationsfunktion 30 ermittelt werden, die eine Korrelation zwischen dem Oberflächenbeschaffenheits-Kennwert 28 der zweiten Kontaktierungsschicht 12 und einem Alterungskennwert 26 der ersten Kontaktierungsschicht 6 festlegt. Auch mittels dieser Korrelation 30 kann der Toleranzbereich 26 für den Kennwert 28 festgelegt werden, sodass ein Signal 34 durch die Auswerteelektronik 18 dann erfolgt, wenn der Alterungskennwert 36 einen kritischen Wert überschritten hat, der mit einem bestimmten Kennwert 28 korreliert. So kann auch eine Alterung der ersten Kontaktierungsschicht 6 beispielsweise durch Mikrorisse zuverlässig im Betrieb der Halbleiterbaugruppe 4 vorhergesagt werden und entsprechende Maßnahmen eingeleitet werden.

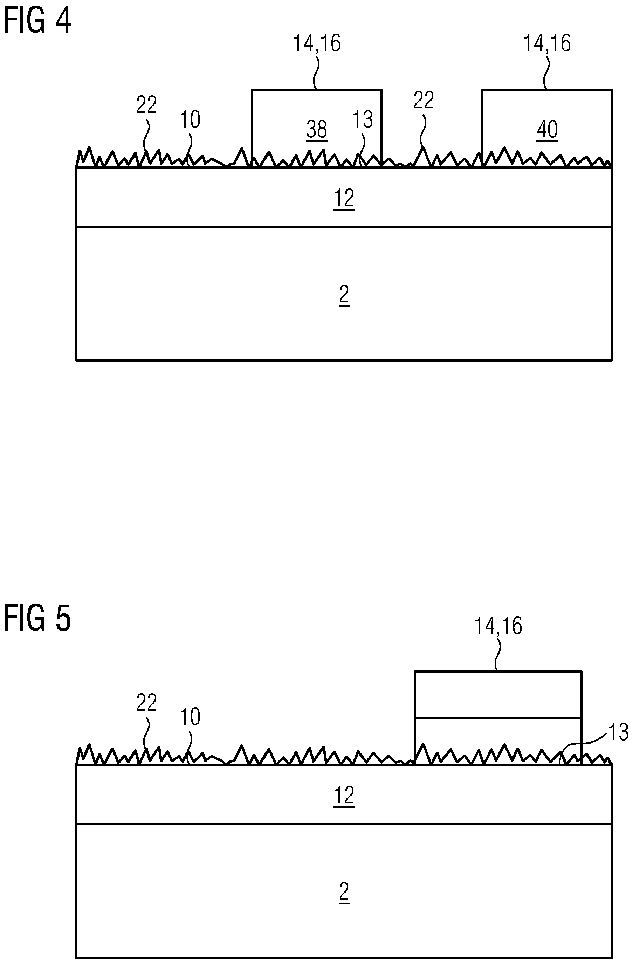

In der Figur 1 ist eine Paarung von Emitter 14 und Sensor 16 dargestellt, die von der Oberfläche 13 der Schicht 12 etwas entfernt angeordnet ist. Wie bereits erwähnt, können diese Kombination, bevorzugt integriert in ein einziges Bauteil, auch direkt auf der Oberfläche 13 der zweiten Kontaktierungsschicht 12 angeordnet sein. Dies ist in Figur 4 und in Figur 5 dargestellt. Hierbei sind jedoch weitere Alternativen zu den vom Emitter 14 in Figur 1 ausgesandten elektromagnetischen Wellen beschrieben. Beispielsweise können neben den elektromagnetischen Wellen vom Emitter 14 auch mechanische Wellen, z. B. in Form von Schallwellen, ausgesandt werden. Hierzu kann der Emitter 14 in Form eines Piezoaktors oder in Form eines MEMS-Aktors ausgestaltet sein. Beide Aktoren dienen als Emitter 14 von Schallwellen, die auf der Oberfläche 13 der Kontaktierungsschicht 12 reflektiert werden und durch einen entsprechenden Schallsensor 16 aufgenommen werden. Die Informationen in Form von Sensordaten werden dabei wiederum analog zu den Figuren 1 und 3 an die Auswerteelektronik 18 weitergegeben.

In Figur 5 ist eine ebenfalls ähnliche Ausgestaltung wie in Figur 4 gegeben, jedoch wird hier als Sensor 16 - Emitter 14 Kombination eine Elektrode mit einem dazwischenliegenden Dialektrikum auf die Oberfläche 13 aufgebracht und es wird hierbei eine Kapazität gemessen, die durch die Oberfläche 13 und ihre Beschaffenheit verändert wird. Sollten mehrere Hillocks 22 vorhanden sein, so ändert sich die Kapazität zwischen dem Dialektrikum und der Elektrode, was als Sensordaten an die Auswerteelektronik 18 weitergegeben wird. Ebenfalls ist es zweckmäßig im vergleichbaren Aufbau nicht die Kapazität, sondern den Widerstand an der Oberfläche 13 zu messen, der ebenfalls charakteristisch durch die Anzahl der Hillocks 22 beeinflusst wird. In dieser Ausgestaltung wird als Emitter 14 die Elektrode angesehen, an der eine entsprechende Spannung oder Ladung anliegt und mit einer hier nicht näher dargestellten Messeinheit als Sensor 16 die entsprechende Kapazität bzw. der Widerstand gemessen wird.

### Bezugszeichenliste

- 2: Halbleiterbauelement
- 4: Halbleiterbaugruppe
- 6: erste Kontaktierungsschicht
- 8: Trägerschicht
- 10: abgewandte Seite
- 12: zweite Kontaktierungsschicht
- 13: Oberfläche
- 14: Emitter
- 16: Sensor
- 18: Auswerkelektronik
- 20: Kontaktierungsdraht
- 22: Hillocks
- 24: Datenbank
- 26: Toleranzbereich
- 28: Oberflächenbeschaffenheits-Kennwert
- 30: Korrelationsfunktion
- 32: Dielektrikum, Widerstand
- 34: Information
- 36: Alterungskennwert
- 38: Piezo-Aktor
- 40: MEMS-Aktor

## Patentansprüche

1. Verfahren zur Bestimmung eines Alterungszustandes einer Kontaktierungsschicht zur Befestigung eines Halbleiterbauelements (2) in einer Halbleiterbaugruppe (4) umfassend folgende Schritte:
- Aufbringen einer ersten Kontaktierungsschicht (6) auf eine Trägerschicht (8), zur Befestigung des Halbleiterbauelement (2) auf dieser Trägerschicht (8),
- wobei auf dem Halbleiterbauelement (2) auf der der ersten Kontaktierungsschicht (6) abgewandten Seite (10) eine zweite Kontaktierungsschicht (12) aufgebracht ist,
- Anbringen eines Emitters (14) und eines Sensors (16) an der Halbleiterbaugruppe (4) die zur Bestimmung einer Oberflächenbeschaffenheit einer Oberfläche (13) der zweiten Kontaktierungsschicht (12) dienen,
- Verbinden des Sensors (16) mit einer Auswerteelektronik (18) für aufgenommene Sensordaten,
- Versetzen der Halbleiterbaugruppe (4) in einen betriebsbereiten Zustand und Betrieb der Halbleiterbaugruppe (4) und
- Auswerten der Sensordaten mittels der Auswerteelektronik (18) im betriebsbereiten Zustand der Halbleiterbaugruppe (4) zur Ermittlung eines Oberflächenbeschaffenheits-Kennwertes der zweiten Kontaktierungsschicht (12).

2. Verfahren nach Anspruch 1, **dadurch gekennzeichnet, dass** in einer Datenbank (24) ein Toleranzbereich (26) für den Oberflächenbeschaffenheits-Kennwert (28) hinterlegt ist und durch die Auswerteelektronik (18) eine Information (34) ausgeschickt wird, wenn ein ermittelter Oberflächenbeschaffenheits-Kennwertes (28) außerhalb des Toleranzbereichs (26) liegt.

3. Verfahren nach Anspruch 2, **dadurch gekennzeichnet, dass** in der Datenbank (24) eine Korrelationsfunktion (30) zwischen dem Oberflächenbeschaffenheits-Kennwert (28) der zweiten Kontaktierungsschicht (12) und einem Alterungskennwert (36) der ersten Kontaktierungsschicht (6) hinterlegt ist.

4. Verfahren nach Anspruch 3, **dadurch gekennzeichnet, dass** die Information (34) dann ausgeschickt wird, wenn der durch die Korrelationsfunktion (30) ermittelte Alterungskennwert (36) außerhalb des Toleranzbereichs (26) liegt.

5. Verfahren nach einem der vorhergehenden Ansprüche, **dadurch gekennzeichnet, dass** der Sensor (16) auf oder an der Oberfläche (13) der zweiten Kontaktierungsschicht (12) angebracht ist.

6. Verfahren nach einem der vorhergehenden Ansprüche, **dadurch gekennzeichnet, dass** mittels des Sensors (16) elektromagnetische oder mechanische Wellen aufgenommen werden, die durch die Oberfläche (13) der zweiten Kontaktierungsschicht (12) beeinflusst werden.

7. Verfahren nach Anspruch 6, **dadurch gekennzeichnet, dass** der Emitter (14) zur Erzeugung von elektromagnetischen Wellen auf die Oberfläche (13) gerichtet ist und der Sensor (16) die von der Oberfläche (13) reflektierten Wellen detektiert und als Sensordaten an die Auswerteelektronik (18) weitergeleitet werden.

8. Verfahren nach Anspruch 6, **dadurch gekennzeichnet, dass** der Emitter (14) zur Erzeugung von mechanischen Wellen auf die Oberfläche (13) gerichtet ist und der Sensor die von der Oberfläche (13) reflektierten Wellen detektiert und als Sensordaten an die Auswerteelektronik (18) weitergeleitet werden.

9. Verfahren nach Anspruch 8, **dadurch gekennzeichnet, dass** die mechanischen Wellen mittels eines Piezo-Aktors (38) oder eines MEMS-Aktors (40) emittiert werden.

10. Verfahren nach Anspruch 9, **dadurch gekennzeichnet, dass** Sensor (16) ein Schallsensor ist.

11. Verfahren nach einem der Ansprüche 1 bis 5, **dadurch gekennzeichnet, dass** mittels des Sensors (16) an der zweiten Kontaktierungsschicht (12) ein kapazitiver oder resistiver Wert als Sensordaten gemessen wird.

12. Halbleiterbaugruppe mit einem Halbleiterbauelement (2), wobei das Halbleiterbauelement (2) mittels einer ersten Kontaktierungsschicht (6) mit einer Trägerschicht (8) verbunden ist und das Halbleiterbauelement (2) auf einer der ersten Kontaktierungsschicht (6) abgewandten Seite (10) eine zweite Kontaktierungsschicht (12) aufweist, **dadurch gekennzeichnet, dass** ein Emitter (14) und ein Sensor (16) an der Halbleiterbaugruppe (4) angeordnet sind, so dass in einem betriebsbereiten Zustand der Halbleiterbaugruppe mittels des Emitters (14) eine Beeinflussung einer Oberfläche (13) der zweiten Kontaktierungsschicht (12) erfolgt, die von dem Sensor (16) detektierbar ist, wobei der Sensor (16) mit einer Auswerteelektronik (18) zur Auswertung von Sensordaten zur Ermittlung eines Oberflächenbeschaffenheits-Kennwertes (28) der Oberfläche (13) in Verbindung steht.

13. Halbleiterbaugruppe nach Anspruch 12, **dadurch gekennzeichnet, dass** Emitter (14) und Sensor (16) dazu geeignet sind, elektromagnetische Wellen oder mechanische Wellen zu emittieren und zu detektieren.

14. Halbleiterbaugruppe nach Anspruch 12, **dadurch gekennzeichnet, dass** der Sensor (16) dazu geeignet ist, resistive oder kapazitive Signale zu detektieren.

15. Halbleiterbaugruppe nach einem der Ansprüche 12 bis 14, **dadurch gekennzeichnet, dass** Emitter (14) und/oder Sensor (16) direkt oder mit einer Beabstandung von maximal 5 mm auf der zweiten Kontaktierungsschicht (12) platziert sind.
